# EUROPEAN PATENT SPECIFICATION

(11) **EP 2 626 970 B1**
(45) Date of publication and mention of the grant of the patent: **03.07.2019**
(21) Application number: 13154498.3
(22) Date of filing: 08.02.2013
(51) Int. Cl.: H02J 7/16

(54) **Battery state of charge determination method and battery state of charge determination apparatus**
Verfahren und Vorrichtung zur Bestimmung des Batterieladezustands
Procédé de détermination de l'état de charge de batterie et appareil de détermination de l'état de charge de batterie

(30) Priority: 10.02.2012 JP 2012027799
(43) Date of publication of application: 14.08.2013
(73) Proprietor: Toyota Jidosha Kabushiki Kaisha, Toyota-shi, Aichi-ken, 471-8571 (JP)
(72) Inventor: Umemoto, Akira, Aichi-Ken 471-8571 (JP)
(74) Representative: Intès, Didier Gérard André

(56) References cited:
- EP-A2- 1 562 273
- EP-A2- 1 858 135
- JP-A- 2009 054 373
- US-A1- 2006 022 643

## Description

### BACKGROUND OF THE INVENTION

### 1. Field of the Invention

The invention relates to a battery state of charge determination method and a battery state of charge determination apparatus for determining that a battery is in a low state of charge condition in which a state of charge of the battery is equal to or smaller than a predetermined state of charge.

### 2. Description of Related Art

A method and apparatus for determining a state of charge of a battery is available in the related art (see Japanese Patent Application Publication No. 2010-271288 (JP-2010-271288 A), for example). In the conventional method and apparatus, a state of charge of a battery during vehicle travel, or in other words during driving of an engine, is calculated on the basis of an estimated open circuit voltage of the battery at a point where a battery charging/discharging current reverses, or in other words reaches zero. The open circuit voltage and the state of charge of the battery typically have a linear relationship. With the method and apparatus described above, therefore, the state of charge of the battery can be determined precisely even during driving of the engine.

During driving of the engine, however, a precision of the estimated open circuit voltage of the battery at the point where the battery charging/discharging current reaches zero is lower than that of a normal open circuit voltage. Therefore, the relationship between the estimated open circuit voltage and the state of charge varies greatly in accordance with travel conditions of the vehicle, a charging/discharging history and a temperature of the battery, and so on. Hence, with the method described in JP-2010-271288 A, the state of charge of the battery may be determined erroneously due to an estimation error in the open circuit voltage of the battery during driving of the engine, and as a result, subsequent battery charging control may not be performed appropriately. EP 1 562 273 A2, EP 1 858 135 A2 and US 2006/022643 A1 also disclose battery state of charge determination methods.

### SUMMARY OF THE INVENTION

The invention provides a battery state of charge determination method and a battery state of charge determination apparatus with which erroneous determination of a battery state of charge can be reduced.

A first aspect of the invention is a battery state of charge determination method including: boosting a power generation voltage of an alternator configured to supply a charging current to a battery such that the charging current supplied to the battery increases; determining whether or not a condition in which the charging current supplied to the battery equals or exceeds a predetermined threshold has been established continuously for a predetermined time after the power generation voltage of the alternator is boosted; and determining that the battery is in a low state of charge condition, in which a state of charge of the battery is equal to or smaller than a predetermined state of charge, when it is determined that the condition in which the charging current supplied to the battery equals or exceeds the predetermined threshold has been established continuously for the predetermined time.

A second aspect of the invention is a battery state of charge determination apparatus including: power generation voltage boosting means for boosting a power generation voltage of an alternator configured to supply a charging current to a battery such that the charging current supplied to the battery increases; condition determining means for determining whether or not a condition in which the charging current supplied to the battery equals or exceeds a predetermined threshold has been established continuously for a predetermined time after the power generation voltage boosting means boosts the power generation voltage of the alternator; and low state of charge condition determining means for determining that the battery is in a low state of charge condition, in which a state of charge of the battery is equal to or smaller than a predetermined state of charge, when the condition determining means determines that the condition in which the charging current supplied to the battery equals or exceeds the predetermined threshold has been established continuously for the predetermined time.

According to the configurations described above, erroneous determination of the battery state of charge can be reduced.

### BRIEF DESCRIPTION OF THE DRAWINGS

Features, advantages, and technical and industrial significance of exemplary embodiments of the invention will be described below with reference to the accompanying drawings, in which like numerals denote like elements, and wherein:
FIG. 1 is an overall constitutional diagram of a system including a battery state of charge determination apparatus according to an embodiment of the invention;
FIG. 2 shows experiment data expressing a relationship between a battery state of charge and a battery charging current following the elapse of a predetermined time after a power generation voltage of an alternator boosted to a predetermined voltage;
FIG. 3 is a flowchart showing an example of a control routine executed in the battery state of charge determination apparatus according to the embodiment; and
FIG. 4 is a view illustrating temporal variation in a power generation voltage instruction value of the alternator and the charging current of the battery in the battery state of charge determination apparatus according to the embodiment.

### DETAILED DESCRIPTION OF EMBODIMENTS

A specific embodiment of the invention will be described below using the drawings.

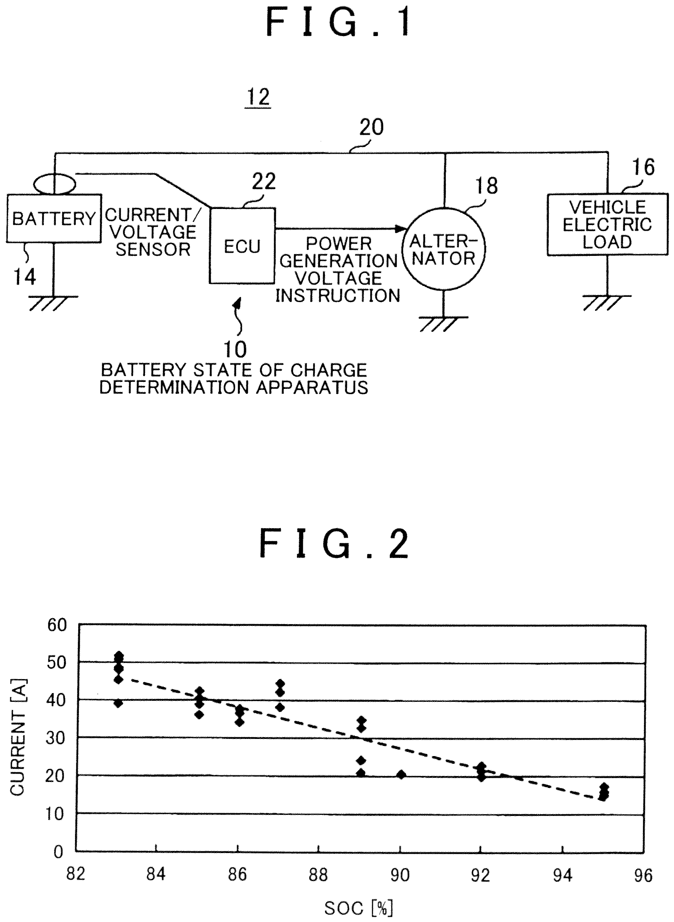

FIG. 1 is an overall view of a system 12 including a battery state of charge determination apparatus 10 serving as an embodiment of the invention. As shown in FIG. 1, the system 12 according to this embodiment includes a battery 14, a vehicle electric load 16, and an alternator 18. The system 12 is an in-vehicle system capable of driving the vehicle electric load 16 by supplying charged power from the battery 14 and generated power from the alternator 18, and charging the battery 14 by supplying generated power from the alternator 18. Further, the battery state of charge determination apparatus 10 is an apparatus that determines a state of charge (SOC) of the battery 14.

The battery 14, the vehicle electric load 16, and the alternator 18 are connected to each other via a power line 20. The battery 14 is a direct current power supply that outputs a voltage of approximately 12 volts, for example. The vehicle electric load 16 is a load driven by a supply of power from the battery 14 and the alternator 18, for example a meter or a lamp. The alternator 18 is driven using an in-vehicle engine as a power supply to convert rotational energy into electric energy, whereupon the alternator 18 supplies power to the vehicle electric load 16 and charges the battery 14 via the power line 20.

The alternator 18 includes a rotor coil, a stator coil, and a rectifying circuit that subjects an output of the stator coil to full-wave rectification. The alternator 18 is driven to generate power in accordance with a current amount flowing to the rotor coil. Alternating current power obtained by power generation in the alternator 18 is rectified by the rectifying circuit so as to be converted into direct current power, whereupon the direct current power is output. The alternator 18 includes a voltage adjustment unit constituted by a switch element (a MOSFET or the like, for example) or the like that is controlled in order to adjust an output power generation voltage. A voltage applied to the rotor coil of the alternator 18 is adjusted by appropriately switch-driving the voltage adjustment unit. Accordingly, an excitation current flowing to the rotor coil is adjusted, whereby the output power generation voltage is adjusted.

An electronic control unit (to be referred to hereafter as an ECU) 22 having a microcomputer as a main component is connected to the alternator 18. Data required to calculate a target power generation voltage to be issued to the alternator 18 as an instruction are input into the ECU 22 from various external sensors. The data input from the external sensors include conditions of the battery 14, an operating condition of the vehicle electric load 16, vehicle traveling conditions, and so on. The conditions of the battery 14 include at least a voltage across the terminals and a charging/discharging current of the battery 14, and may further include a battery temperature and so on. The vehicle traveling conditions include the engine operating condition and the accelerator ON/OFF condition, for example. The target power generation voltage is a voltage corresponding to an amount of power to be supplied to at least one of the vehicle electric load 16 and the battery 14 from the alternator 18.

The ECU 22 calculates a target power generation voltage (a power generation voltage instruction value) periodically on the basis of the input data. Target power generation voltages that can be issued to the alternator 18 as instructions may be limited to a predetermined instruction range (a range of 13.8 volts to 14.8 volts, for example), and the value set as the target power generation voltage may be selected from a plurality of values determined in advance as values within the predetermined instruction range. The ECU 22 performs power generation control on the alternator 18 on the basis of the target power generation voltage of the alternator 18. More specifically, the ECU 22 switch-drives the voltage adjustment unit of the alternator 18 such that the target power generation voltage is realized.

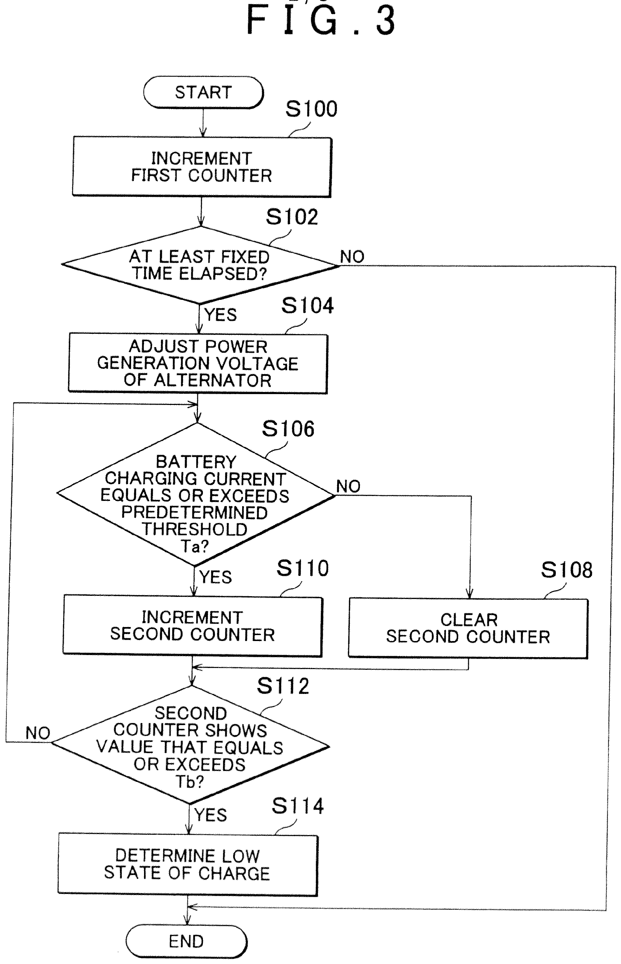

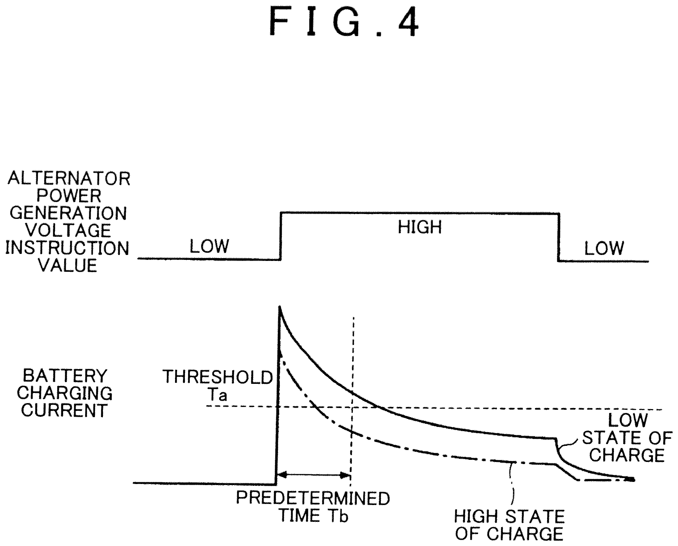

Next, referring to FIGS. 2 to 4, an operation of the battery state of charge determination apparatus 10 according to this embodiment will be described. FIG. 2 shows experiment data expressing a relationship between the battery state of charge and a battery charging current following the elapse of a predetermined time after the power generation voltage of the alternator 18 is boosted from a first voltage to a second voltage. FIG. 3 is a flowchart showing an example of a control routine executed by the ECU 22 in the battery state of charge determination apparatus 10 according to this embodiment. FIG. 4 is a view illustrating temporal variation in the power generation voltage instruction value of the alternator 18 and the charging current of the battery 14 in the battery state of charge determination apparatus 10 according to this embodiment. Note that in FIG. 4, a case in which the battery 14 is in a low state of charge condition and a case in which the battery 14 is in a high state of charge condition are indicated by a thick solid line and a dot-dash line, respectively.

In this embodiment, as described above, the ECU 22 calculates the target power generation voltage periodically on the basis of the input data. The ECU 22 then causes the alternator 18 to generate power on the basis of the target power generation voltage. More specifically, the ECU 22 switch-drives the voltage adjustment unit such that the target power generation voltage is realized. When the voltage adjustment unit is switch-driven, an appropriate amount of current flows to the rotor coil, and as a result, the alternator 18 is caused to perform power generation such that the target power generation voltage is realized.

Incidentally, assuming that identical data are input into the ECU 22 on the basis of identical vehicle travel conditions, battery conditions, and so on, the charging current of the battery 14 upon the elapse of a predetermined time (10 seconds, for example) after the power generation voltage of the alternator 18 is boosted from a comparatively low first voltage (13.8 volts, for example) to a comparatively high second voltage (14.8 volts, for example) varies in accordance with the state of charge of the battery 14 at that time. More specifically, as shown in FIG. 2, the charging current of the battery 14 at the elapse point of the predetermined time decreases linearly as the state of charge of the battery 14 increases and increases linearly as the state of charge of the battery 14 decreases.

In this embodiment, first, the ECU 22 executes processing to increment a counter (to be referred to hereafter as a first counter) that measures time while a vehicle ignition is ON, or in other words while an engine is driven (Step 100). After incrementing the first counter, the ECU 22 determines whether or not the first counter shows a value that equals or exceeds a fixed time (Step 102). The first counter is cleared when the ignition is switched OFF or ON or when the battery 14 is determined to be in the low state of charge condition, as will be described below. The fixed time may be a predetermined time set in advance.

When the first counter shows a value that is smaller than the fixed time, the ECU 22 determines that the fixed time has not elapsed, and therefore terminates the current routine without performing any further processing. When the first counter shows a value that equals or exceeds the fixed time, on the other hand, the ECU 22 determines that the fixed time has elapsed, and therefore performs an adjustment to boost the power generation voltage of the alternator 18 above a normal power generation voltage (Step 104). More specifically, the ECU 22 sets a higher voltage than a normal target power generation voltage calculated on the basis of the input data as a target power generation voltage following boosting of the power generation voltage of the alternator 18 (a boosted target power generation voltage).

The boosted target power generation voltage may take any value obtained by adding a predetermined voltage to the normal target power generation voltage, for example a value one level higher than the normal target power generation voltage. Further, execution of the processing for boosting the power generation voltage may be permitted only when the normal target power generation voltage calculated on the basis of the input data is smaller than a value which is lower than an upper limit value of the instruction range of the power generation voltages that can be issued to the alternator 18 as instructions by a predetermined voltage.

When the power generation voltage of the alternator 18 is boosted, an ability of the battery 14 to receive the charging current improves. Therefore, as shown in FIG. 4, the charging current of the battery 14 following boosting of the power generation voltage (the power generation voltage instruction value) is much higher than the charging current of the battery 14 prior to boosting of the generated power. Further, the charging current of the battery 14 decreases gradually over time after increasing in response to boosting of the power generation voltage. A decrease speed of the charging current at this time differs according to the state of charge of the battery 14. More specifically, the decrease speed of the charging current increases as the state of charge increases and decreases as the state of charge decreases.

After executing the processing of Step 104, the ECU 22 determines whether or not the charging current of the battery 14 equals or exceeds a predetermined threshold Ta (Step 106). The predetermined threshold Ta is a boundary value of the battery charging current used to differentiate the low state of charge condition of the battery 14 from the high state of charge condition of the battery 14, and is set at 35 ampere, for example. The low state of charge condition of the battery 14 is a condition in which the state of charge is equal to or smaller than a predetermined state of charge (88%, for example), while the high state of charge condition of the battery 14 is a condition in which the state of charge exceeds the predetermined state of charge.

When determining in Step 106 that the charging current of the battery 14 is smaller than the predetermined threshold Ta, the ECU 22 executes processing to clear a counter (to be referred to hereafter as a second counter) that measures a duration of a high charging current condition in which the charging current of the battery 14 equals or exceeds the predetermined threshold Ta (Step 108). When determining in Step 106 that the charging current of the battery 14 equals or exceeds the predetermined threshold Ta, on the other hand, the ECU 22 executes processing to increment the second counter (Step 110).

After executing the processing of Step 108 or Step 110, the ECU 22 determines whether or not the second counter shows a value that equals or exceeds a predetermined time Tb (Step 112). The predetermined time Tb is a boundary value of the duration of the high charging current condition, and is set at 10 seconds, for example.

When the second counter shows a smaller value than the predetermined time Tb in Step 112, the ECU 22 determines that the high charging current condition has not been established continuously for the predetermined time Tb, and therefore repeats the processing of Step 106 onward. When the second counter shows a value that equals or exceeds the predetermined time Tb in Step 112, on the other hand, the ECU 22 determines that the high charging current condition has been established continuously for the predetermined time Tb, and therefore determines that the battery 14 is in the low state of charge condition (Step 114).

Hence, in the battery state of charge determination apparatus 10 according to this embodiment, when the high charging current condition, in which the charging current of the battery 14 equals or exceeds the predetermined threshold Ta, has not been established continuously for the predetermined time Tb after the power generation voltage of the alternator 18 is boosted above the normal value, the battery 14 is not determined to be in the low state of charge condition, but when the high charging current condition has been established continuously for the predetermined time Tb, the battery 14 is determined to be in the low state of charge condition.

As described above, the charging current of the battery 14 following boosting of the power generation voltage of the alternator 18 is much higher than the charging current of the battery 14 prior to boosting. Further, the charging current of the battery 14 decreases gradually over time after increasing, while the decrease speed of the charging current increases as the state of charge of the battery 14 increases and decreases as the state of charge of the battery 14 decreases. Hence, with the battery state of charge determination apparatus 10 according to this embodiment, it is possible to determine accurately whether or not the battery 14 is in the low state of charge condition, and therefore erroneous determination of the battery state of charge (for example, a situation in which the battery 14 is determined to be in the high state of charge condition despite actually being in the low state of charge condition, or the like) can be reduced.

Furthermore, in this embodiment, the power generation voltage of the alternator 18 is boosted from the normal value at fixed time intervals while the engine is driven. Hence, with the battery state of charge determination apparatus 10 according to this embodiment, the battery state of charge can be determined at fixed time intervals while the engine is driven, and it is therefore possible to determine that the battery 14 is in the low state of charge condition quickly even during engine driving.

In the above embodiment, the processing of Step 104 in the routine shown in FIG. 3, which is executed by the ECU 22, functions as power generation voltage boosting means, the processing of Step 112 functions as condition determining means, and the processing of Step 114 functions as low state of charge condition determining means.

In the above embodiment, the state of charge condition of the battery 14 is determined to belong to either the low state of charge condition or the high state of charge condition, i.e. in binary terms, on the basis of whether or not the condition in which the charging current of the battery 14 equals or exceeds the predetermined threshold Ta has been established continuously for the predetermined time Tb. However, the state of charge condition of the battery 14 may be determined to belong to one of three or more state of charge conditions on the basis of the relationship between the charging current of the battery 14 and the duration.

## Claims

1. A battery state of charge determination method **characterized by**:
boosting a power generation voltage of an alternator (18) configured to supply a charging current to a battery (14) such that the charging current supplied to the battery (14) increases;
determining whether or not the condition in which the charging current supplied to the battery (14) equals or exceeds a predetermined threshold (Ta) has been established continuously for a predetermined time (Tb) after the power generation voltage of the alternator (18) is boosted; and
determining that the battery (14) is in a low state of charge condition, in which a state of charge of the battery (14) is equal to or smaller than a predetermined state of charge, when it is determined that the condition in which the charging current supplied to the battery (14) equals or exceeds the predetermined threshold (Ta) has been established continuously for the predetermined time (Tb).

2. The battery state of charge determination method according to claim 1, wherein the power generation voltage of the alternator (18) is boosted at fixed time intervals while an engine is driven.

3. The battery state of charge determination method according to claim 1 or 2, wherein the power generation voltage of the alternator (18) is boosted to a higher voltage than a target power generation voltage of the alternator (18) calculated on the basis of at least a condition of the battery (14).

4. A battery state of charge determination apparatus (10) **characterized by**:
power generation voltage boosting means (S104) for boosting a power generation voltage of an alternator (18) configured to supply a charging current to a battery (14) such that the charging current supplied to the battery (14) increases;
condition determining means (S112) for determining whether or not the condition in which the charging current supplied to the battery (14) equals or exceeds a predetermined threshold (Ta) has been established continuously for a predetermined time (Tb) after the power generation voltage boosting means (S104) boosts the power generation voltage of the alternator (18); and
low state of charge condition determining means (S114) for determining that the battery (14) is in a low state of charge condition, in which a state of charge of the battery (14) is equal to or smaller than a predetermined state of charge, when the condition determining means (S112) determines that the condition in which the charging current supplied to the battery (14) equals or exceeds the predetermined threshold (Ta) has been established continuously for the predetermined time (Tb).

5. The battery state of charge determination apparatus according to claim 4, wherein the power generation voltage boosting means (S104) boosts the power generation voltage of the alternator (18) at fixed time intervals while an engine is driven.

6. The battery state of charge determination apparatus according to claim 4 or 5, wherein the power generation voltage boosting means (S104) boosts the power generation voltage of the alternator (18) to a higher voltage than a target power generation voltage of the alternator (18) calculated on the basis of at least a condition of the battery (14).

## Patentansprüche

1. Batterieladezustandsbestimmungsverfahren, **gekennzeichnet durch**:
Verstärken einer Energieerzeugungsspannung eines Wechselstromgenerators (18), der dazu ausgebildet ist, einer Batterie (14) einen Ladestrom zuzuführen, derart, dass der der Batterie (14) zugeführte Ladestrom zunimmt,
Bestimmen, ob der Zustand, in dem der der Batterie (14) zugeführte Ladestrom größer oder gleich einer vorbestimmten Schwelle (Ta) ist, kontinuierlich eine vorbestimmte Zeit (Tb) lang, nachdem die Energieerzeugungsspannung des Wechselstromgenerators (18) verstärkt wird, hergestellt wurde oder nicht, und
Bestimmen, dass die Batterie (14) in einem niedrigen Ladezustand ist, in dem ein Ladezustand der Batterie (14) kleiner gleich einem vorbestimmten Ladezustand ist, wenn bestimmt wird, dass der Zustand, in dem der der Batterie (14) zugeführte Ladestrom größer oder gleich der vorbestimmten Schwelle (Ta) ist, kontinuierlich die vorbestimmte Zeit (Tb) lang hergestellt wurde.

2. Batterieladezustandsbestimmungsverfahren nach Anspruch 1, wobei die Energieerzeugungsspannung des Wechselstromgenerators (18) in festen Zeitabständen verstärkt wird, während ein Motor betrieben wird.

3. Batterieladezustandsbestimmungsverfahren nach Anspruch 1 oder 2, wobei die Energieerzeugungsspannung des Wechselstromgenerators (18) auf eine höhere Spannung als eine Sollenergieerzeugungsspannung des Wechselstromgenerators (18) verstärkt wird, die auf der Basis von mindestens einem Zustand der Batterie (14) berechnet wird.

4. Batterieladezustandsbestimmungsvorrichtung (10), **gekennzeichnet durch**:
ein Energieerzeugungsspannungsverstärkungsmittel (S104) zum Verstärken einer Energieerzeugungsspannung eines Wechselstromgenerators (18), der dazu ausgebildet ist, einer Batterie (14) einen Ladestrom zuzuführen, derart, dass der der Batterie (14) zugeführte Ladestrom zunimmt,
ein Zustandsbestimmungsmittei (S112) zum Bestimmen, ob der Zustand, in dem der der Batterie (14) zugeführte Ladestrom größer oder gleich einer vorbestimmten Schwelle (Ta) ist, kontinuierlich eine vorbestimmte Zeit (Tb) lang, nachdem das Energieerzeugungsspannungsverstärkungsmittel (S104) die Energieerzeugungsspannung des Wechselstromgenerators (18) verstärkt, hergestellt wurde oder nicht, und
ein Niedrigladezustandsbestimmungsmittel (S114) zum Bestimmen, dass die Batterie (14) in einem niedrigen Ladezustand ist, in dem ein Ladezustand der Batterie (14) kleiner oder gleich einem vorbestimmten Ladezustand ist, wenn das Zustandsbestimmungsmittel (S112) bestimmt, dass der Zustand, in dem der der Batterie (14) zugeführte Ladestrom größer oder gleich der vorbestimmten Schwelle (Ta) ist, kontinuierlich die vorbestimmte Zeit (Tb) lang hergestellt wurde.

5. Batterieiadezustandsbestimmungsvorrichtung nach Anspruch 4, wobei das Energieerzeugungsspannungsverstärkungsmittel (S104) die Energieerzeugungsspannung des Wechselstromgenerators (18) in festen Zeitabständen verstärkt, während ein Motor betrieben wird.

6. Batterieladezustandsbestimmungsvorrichtung nach Anspruch 4 oder 5, wobei das Energieerzeugungsspannungsverstärkungsmittel (S104) die Energieerzeugungsspannung des Wechselstromgenerators (18) auf eine höhere Spannung als eine Sollenergieerzeugungsspannung des Wechselstromgenerators (18) verstärkt, die auf der Basis von mindestens einem Zustand der Batterie (14) berechnet wird.

## Revendications

1. Procédé de détermination d'état de charge de batterie **caractérisé par** le fait de :
amplifier une tension de génération de puissance d'un alternateur (18) configuré pour délivrer un courant de charge à une batterie (14) de telle sorte que le courant de charge délivré à la batterie (14) augmente ;
déterminer si la condition dans laquelle le courant de charge délivré à la batterie (14) égale ou dépasse un seuil prédéterminé (Ta) a été établie ou non de manière continue pendant un temps prédéterminé (Tb) après que la tension de génération de puissance de l'alternateur (18) a été amplifiée ; et
déterminer que la batterie (14) est dans une condition de faible état de charge, dans laquelle un état de charge de la batterie (14) est égal ou inférieur à un état de charge prédéterminé, lorsqu'il est déterminé que la condition dans laquelle le courant de charge délivré à la batterie (14) égale ou dépasse le seuil prédéterminé (Ta) a été établie de manière continue pendant le temps prédéterminé (Tb).

2. Procédé de détermination d'état de charge de batterie selon la revendication 1, selon lequel la tension de génération de puissance de l'alternateur (18) est amplifiée à des intervalles de temps fixes pendant qu'un moteur thermique fonctionne.

3. Procédé de détermination d'état de charge de batterie selon la revendication 1 ou 2, selon lequel la tension de génération de puissance de l'alternateur (18) est amplifiée à une tension plus élevée qu'une tension de génération de puissance de cible de l'alternateur (18) calculée sur la base d'au moins un état de la batterie (14) .

4. Appareil de détermination d'état de charge de batterie (10) **caractérisé par** :
des moyens d'amplification de tension de génération de puissance (S104) pour amplifier une tension de génération de puissance d'un alternateur (18) configuré pour délivrer un courant de charge à une batterie (14) de telle sorte que le courant de charge délivré à la batterie (14) augmente ;
des moyens de détermination de condition (S112) pour déterminer si la condition dans laquelle le courant de charge délivré à la batterie (14) égale ou dépasse un seuil prédéterminé (Ta) a été établie ou non de manière continue pendant un temps prédéterminé (Tb) après que les moyens d'amplification de tension de génération de puissance (S104) ont amplifié la tension de génération de puissance de l'alternateur (18) ; et
des moyens de détermination de condition de faible état de charge (S114) pour déterminer que la batterie (14) est dans une condition de faible état de charge, dans laquelle un état de charge de la batterie (14) est égal ou inférieur à un état de charge prédéterminé, quand les moyens de détermination de condition (S112) déterminent que la condition dans laquelle le courant de charge délivré à la batterie (14) égale ou dépasse le seuil prédéterminé (Tb) a été établie de manière continue pendant le temps prédéterminé (Tb).

5. Appareil de détermination d'état de charge de batterie selon la revendication 4, dans lequel les moyens d'amplification de tension de génération de puissance (S104) amplifient la tension de génération de puissance de l'alternateur (18) à des intervalles de temps fixes pendant qu'un moteur thermique fonctionne.

6. Appareil de détermination d'état de charge de batterie selon la revendication 4 ou 5, dans lequel les moyens d'amplification de tension de génération de puissance (S104) amplifient la tension de génération de puissance de l'alternateur (18) à une tension plus élevée qu'une tension de génération de puissance de cible de l'alternateur (18) calculée sur la base d'au moins un état de la batterie (14).
